# EUROPÄISCHE PATENTSCHRIFT

(11) **EP 1 241 013 B1**
(45) Veröffentlichungstag und Bekanntmachung des Hinweises auf die Patenterteilung: **13.12.2006**
(21) Anmeldenummer: 02003162.1
(22) Anmeldetag: 15.02.2002
(51) Int. Cl.: B41J 2/447

(54) **Bebilderungseinrichtung für eine Druckform mit einem Array von VCSEL-Lichtquellen**
Imaging device for a printing plate with an array of VCSEL-light sources
Dispositif de formation d'image pour une plaque d'impression avec une matrice de sources lumineuses VCSEL

(30) Priorität: 13.03.2001 DE 10111871
(43) Veröffentlichungstag der Anmeldung: 18.09.2002
(73) Patentinhaber: Heidelberger Druckmaschinen Aktiengesellschaft, 69115 Heidelberg (DE)
(72) Erfinder: Beier, Bernard, Dr., 68526 Ladenburg (DE); Vosseler, Bernd, 69120 Heidelberg (DE)

(56) Entgegenhaltungen:
- EP-A- 0 905 835
- US-A- 4 900 130
- US-A- 5 477 259
- US-A- 5 793 783
- PATENT ABSTRACTS OF JAPAN vol. 2000, no. 05, 14. September 2000 (2000-09-14) & JP 2000 043317 A (DAINIPPON SCREEN MFG CO LTD), 15. Februar 2000 (2000-02-15) & US 6 249 306 A (ISONO KOICHI) 19. Juni 2001 (2001-06-19)

## Beschreibung

Die Erfindung betrifft eine Einrichtung zur Bebilderung einer Druckform mit einem Array von Lichtquellen und einer Abbildungsoptik zur Erzeugung von (n x m) Bildpunkten auf der Druckform, wobei n>1 und m>=1 natürliche Zahlen sind.

Die Bebilderungszeit von Druckformen, sei es in einem Druckformbelichter oder in einem Druckwerk, wird wesentlich durch die Anzahl der zur Verfügung stehenden Bebilderungskanäle bestimmt. Typische Bebilderungseinrichtungen weisen daher eine Mehrzahl von Lichtquellen, wobei wenigstens eine Lichtquelle einem Bebilderungskanal zugeordnet ist, auf. Durch einen Bebilderungskanal wird ein Bildpunkt auf die Oberfläche einer Druckform projiziert, so dass Druckpunkte auf der Druckform gesetzt werden können. Die Literatur umfasst eine große Anzahl von Dokumenten, welche sich mit Mehrstrahlbebilderung von Druckformen beschäftigen.

Beispielsweise wird in der US 5,291,329 eine Einrichtung zur Bildaufzeichnung offenbart, in der eine Mehrzahl von zweidimensional angeordneten Laserlichtquellen mittels einer Abbildungsoptik auf eine Aufzeichnungsfläche zur Erzeugung einer Mehrzahl von Bildpunkten abgebildet wird. Die Laserlichtquellen sind dabei derart angeordnet, typischerweise auf einem Kugelschalensektor, dass der Hauptstrahl eines jeden Lasers durch einen Fokus einer ersten Linse der Abbildungsoptik verläuft.

Um einen geringeren Abstand der Bildpunkte zueinander zu erzielen, ist in der US 5,995,475 ein zweidimensionales Array aus individuellen Multimode-Laserdioden mit separaten Kollimationslinsen beschrieben. Das Array wird unter einer starken Verkleinerung auf ein Bebilderungsmedium abgebildet. Die Abbildungsoptik umfasst dabei anamorphotische optische Elemente zur Strahlformung des divergenten Laserlichts.

Diesen Bebilderungseinrichtungen ist gemein, dass sie kantenemittierende Diodenlaser für die Erzeugung der Laserstrahlung verwenden. Eine nachteilige Eigenschaft von kantenemittierenden Diodenlasern ist jedoch, dass diese Laserstrahlung mit einem großen Divergenzwinkel und einem starken Astigmatismus aufweisen, so dass die Bündelung der Laserstrahlung sehr aufwendig ist und meist ein aufwendiges optisches Linsensystem benötigt wird. Darüber hinaus müssen kantenemittierende Diodenlaser vor einem Funktionstest zunächst aus dem Wafer gebrochen und montiert werden. Diese Fertigungsschritte sind teilweise sehr aufwendig, reduzieren die Ausbeute bei der Herstellung und erhöhen dadurch den Preis der Laser.

Während konventionelle Halbleiterlaser Kantenemitter sind, die Lichtausbreitung also senkrecht zur Fläche des pn-Übergangs erfolgt und das Licht senkrecht aus den Spaltflächen des Chips austritt, sind sogenannte oberflächenemittierende Laserdioden (VCSEL-Laserdioden, Vertical-Cavity-Surface-Emitting-Laser) bekannt, welche senkrecht zur Waferoberfläche abstrahlen. Die Resonator Achse steht nun parallel auf der Fläche des pn-Übergangs. Im Zusammenhang dieser Darstellung und der erfindungsgemäßen Einrichtung können unter dem Begriff einer VCSEL-Lichtquelle sämtliche Diodenlaser verstanden sein, deren Abstrahlungsrichtung senkrecht zur aktiven Zone liegt. Es kann sich dabei insbesondere um Oberflächenemitter, deren Resonatorlänge kurz verglichen zur Dicke der aktiven Zone, um Oberflächenemitter, deren Resonatoren monolithisch verlängert sind, oder um Oberflächenemitter, die einen externen oder einen gekoppelten Resonator aufweisen (auch als NECSELs bezeichnet), handeln. Des weiteren kann eine VCSEL-Lichtquelle ein Diodenlaser sein, dessen Resonator im wesentlichen parallel zur aktiven Zone liegt und mit einer beugenden oder reflektierenden Struktur versehen ist, welche die Laserstrahlung senkrecht zur aktiven Zone auskoppelt.

Im allgemeinen gilt für VCSEL-Lichtquellen, dass die aktive Länge des Resonators sehr kurz sein kann, typischerweise nur wenige Mikrometer beträgt, und dass hochreflektierende Resonatorspiegel erforderlich sind, um kleine Schwellströme zu bekommen. Oberflächenemittierende Laserdioden, VCSEL-Lichtquellen, haben zahlreiche interessante Eigenschaften. Durch einen extrem kurzen Resonator, oft unter 10 Mikrometer Länge, erreicht man einen großen longitudinalen Modenabstand, welcher oberhalb der Laserschwelle Einmodenemission fördert. Durch einen rotationssymetrischen Resonator von typisch 6 bis 8 Mikrometer Durchmesser erhält man ein kreisrundes Nahfeld und - durch den relativ großen Durchmesser bedingt - eine kleine Strahldivergenz. Die Bauform des Lasers erlaubt darüber hinaus eine einfache monolithische Integration zweidimensionaler VCSEL-Laserdioden Arrays. Schließlich ist ein Testen der Laser unmittelbar auf der Waferscheibe nach der Fertigung möglich.

Der typische Schichtaufbau eines oberflächenemittierenden Lasers ist dem Fachmann bekannt und kann entsprechender Literatur entnommen werden (Siehe zum Beispiel K.J. Ebeling "Integrierte Optoelektronik", Springer-Verlag, Berlin, 1992). Beispielsweise wird in der EP 090 5 835 A1 ein zweidimensionales Array von VCSEL-Lichtquellen beschrieben, welche einzeln adressierbar oder ansteuerbar sind.

Typische VCSEL-Lichtquellen weisen allerdings nur eine geringe Ausgangsleistung auf. Zur Erhöhung der erreichbaren Ausgangsleistung und zur Erzwingung einer Laseroszillation in der Fundamentalmode ist in der US 5,838,715 eine spezielle Resonatorform für eine VCSEL-Schichtstruktur offenbart. Nachteilig bei einer derartigen Vorgehensweise ist aber unter anderem die aufwendige Fertigung.

In diesem Zusammenhang ist es erwähnenswert, dass aus der Literatur auch bekannt ist, dass Licht mehrerer Emitterdioden zur Generierung eines intensiven Lichtstrahls durch entsprechende Abbildungsoptik zusammengefasst wird. Beispielsweise wird in der US 5,793,783 beschrieben, wie Licht einer Mehrzahl von Lichtquellen oder Teilarrays von Lichtquellen in einem Array zu einem überlappenden Fokus konvergiert wird.

Des Weiteren ist aus der Literatur geläufig, beispielsweise US 5,477,259, dass ein Array von Lichtquellen aus einzelnen Modulen von Teilarrays zusammengesetzt werden kann. Typischerweise handelt es sich dabei um eine Reihe, also eindimensional angeordnete Laserdioden, welche nebeneinander auf einem Aufnahmeelement fixiert sind, so dass ein zweidimensionales Array von Lichtquellen entsteht.

Eine Bebilderung einer Druckform mit einem eindimensionalen oder zweidimensionalen Array von Bildpunkten erfolgt typischerweise in zwei Klassen von Bebilderungsverfahren. Der ersten Klasse liegt zugrunde, dass die Bildpunkte der Bebilderungslichtquellen dicht liegen. Mit anderen Worten: Der Abstand der Bebilderungspunkte entspricht dem Abstand der zu setzenden Druckpunkte. Ein Überstreichen der zu bebildernden zweidimensionalen Druckform erfolgt dann durch Translation in die zwei linear unabhängigen die Fläche aufspannenden Richtungen. Die zweite Klasse von Bebilderungsverfahren zeichnet sich dadurch aus, dass der Abstand der Bildpunkte größer als der Abstand benachbarter zu setzender Druckpunkte ist. Um eine vollständige Bebilderung der zweidimensionalen Druckform zu erreichen, ist es daher erforderlich, dass Bildpunkte eines bestimmten Bebilderungsschrittes zwischen Bildpunkten eines zeitlich vorhergehenden Bebilderungsschrittes zu liegen kommen. Derartige Verfahren werden auch als Interleafverfahren bezeichnet. Als ein Beispiel für ein derartiges Interleafverfahren sei hier die US 4,900,130 angeführt. In diesem Dokument wird sowohl ein eindimensionales als auch ein zweidimensionales Interleafverfahren von Rasterscanlinien für ein ein- bzw. zweidimensionalen Array von Lichtquellen offenbart, dessen Bildpunkte auf einem Bebilderungsmedium im größeren Abstand als benachbarte Druckpunkte liegen.

Aufgabe der vorliegenden Erfindung ist es daher, eine Einrichtung zur Bebilderung einer Druckform zu schaffen, welche mit einer Vielzahl von Bebilderungskanälen schreiben kann, deren Licht vorteilhafte Strahleigenschaften aufweist und deren Brennpunkte mit einfacher Optik erzeugt werden können. Des Weiteren soll eine große Systemlebensdauer erreicht und eine Reparatur bei Teilausfällen mit geringem Aufwand ermöglicht werden.

Diese Aufgabe wird durch eine Einrichtung zur Bebilderung einer Druckform mit den Merkmalen gemäß Anspruch 1 gelöst. Vorteilhafte Ausführungsformen und Weiterbildungen der erfindungsgemäßen Einrichtung sind in den Unteransprüchen charakterisiert.

Die erfindungsgemäße Einrichtung zur Bebilderung einer Druckform weist ein Array von Lichtquellen und eine Abbildungsoptik zur Erzeugung von (n x m) Bildpunkten auf der Druckform auf, wobei n>1 und m>=1 natürliche Zahlen sind. Sie zeichnet sich dadurch aus, dass das Array von Lichtquellen ein Array von (r x s) VCSEL-Lichtquellen umfasst, wovon wenigsten zwei VCSEL-Lichtquellen unabhängig voneinander ansteuerbar sind, wobei r>=n und s>=m natürliche Zahlen sind. Oberflächenemittierende Diodenlaser (VCSEL) weisen vorteilhafte Strahleigenschaften auf. Aufgrund der ausgedehnten Emitterfläche wird die Strahlung mit einem geringen Divergenzwinkel emittiert. Die Strahlqualität und die Form des emittierten Strahls ist im wesentlichen durch die Größe der Auskoppelfacette bestimmt. Durch die Auswahl einer bestimmten Größe erzeugt ein VCSEL Strahlung in der Grundmode des Resonators (Gaußscher Strahl), welcher für die Bebilderung einer Druckplatte aufgrund der hohen Tiefenschärfe besonders vorteilhaft ist. Im Gegensatz zu kantenemittierenden Lasern sind Strahldurchmesser und Divergenzwinkel in den linear unabhängigen den Strahldurchmesser aufspannenden Richtungen gleich, so dass eine Kollimation und eine Fokussierung mit relativ einfachen optischen Elementen (weniger asymmetrische und/oder asphärische Elemente), auch in Form von Mikrolinsenarrays, erreicht werden kann. Durch eine geeignete Kontaktierung der einzelnen VCSEL im Array ist eine separate, voneinander unabhängige Ansteuerbarkeit der einzelnen Laser gewährleistet, so dass die Lichtintensität in den VCSEL-Lichtquellen zugeordneten Bebilderungskanälen verändert werden kann.

Mit anderen Worten ist eine wichtige Idee der Erfindung, ein VCSEL-Array zur Bebilderung von Druckformen zu verwenden, bei dem für jeden Bebilderungskanal eine ausreichend hohe Ausgangsleistung durch VCSEL-Emitter in einer vorteilhaften Resonatormode erzeugt wird. Mittels eines einzeln ansteuerbaren Arrays ist es möglich, in jedem Bebilderungskanal eine der Bebilderungsinformation entsprechende Intensität dem Bildpunkt aufzuprägen. Um eine höhere Leistung pro Bebilderungskanal zu erreichen, kann es vorteilhaft sein, neben der Grundmode des Resonators auch weitere Moden anzuregen.

Insbesondere zur Erhöhung der zur Verfügung stehenden Leistung kann die Einrichtung zur Bebilderung einer Druckform derart ausgeführt sein, dass wenigstens ein Bildpunkt auf der Druckform durch die Zusammenführung des von einem Teilarray der (r x s) VCSEL-Lichtquellen emittierten Lichtes, also wenigstens zweier VCSEL-Lichtquellen entsteht. Durch eine derartige Zuordnung mehrerer VCSEL-Lichtquellen zu einem Bebilderungskanal wird gleichzeitig vorteilhaft die Redundanz und die Systemlebensdauer erhöht. Bei einem Ausfall einer VCSEL-Lichtquelle stehen noch weitere innerhalb des Bebilderungskanals zur Verfügung.

Es ist besonders vorteilhaft, die Einrichtung zur Bebilderung einer Druckform mit einem Array von VCSEL-Lichtquellen zu versehen, welches aus einer Anzahl von Unterarrays modular aufgebaut ist. Mit anderen Worten das Gesamtarray der (r x s) VCSEL-Lichtquellen kann aus einzelnen Streifen oder Blöcken, welche jeweils mehrere VCSEL-Lichtquellen umfassen, beispielsweise s Blöcke mit r Oberflächenemittern, zusammengesetzt werden. Im Falle eines Teilausfalles bestimmter Lichtquellen können dann diese schnell, einfach und preisgünstig ersetzt werden.

In einer alternativen Ausführungsform der erfindungsgemäßen Einrichtung, welche ovale Foki auf einer Druckform erzeugt, bevorzugt mit einer Elliptizität von mindestens 1%, sei es aufgrund einer elliptischen Geometrie der Oberflächenemitter oder aufgrund einer geeigneten Optik, kann bezogen auf die Bewegungsrichtung mit einem querelliptischen (oblaten) Strahl eine höhere Energiedichte und mit einem längselliptischen (prolaten) Strahl eine günstigere zeitliche Einkoppelung der Energie in die Druckform erreicht werden als unter Verwendung eines runden Strahls, der die gleiche Linienbreite erzeugt.

Zu den Eigenschaften von VCSEL-Arrays gehört es, dass die Substratkanten frei sind und nicht, wie bei kantenemittierenden Diodenlasern die Funktion der emittierenden Facette haben. Dadurch ist es möglich, dass die Kanten sehr genau bearbeitet werden können, so dass einzelne Arrays zueinander positioniert werden können. Dies ermöglicht die Anordnung mehrerer ein- oder zweidimensionaler VCSEL-Arrays zu einem größeren Array, also die Anordnung von Unterarrays zu einem (r x s) Array von VCSEL-Lichtquellen, bei dem sich die Regelmäßigkeit der geometrischen Anordnung der Emitter auf das gesamte Array erstreckt. Es ist also möglich durch modularen Aufbau sehr große Arrays zu erreichen, wobei ein Ausfall einzelner Emitter auf einem Modul durch den Austausch nur des betroffenen Moduls einfach behebbar ist.

Eine gute Kühlung kann ermöglicht werden, wenn in einer vorteilhaften Ausführungsform der erfindungsgemäßen Einrichtung zur Bebilderung die VCSEL mit der p-Seite nach unten (auf einen Träger oder einem Aufnahmeelement) montiert werden.

Durch eine zweidimensionale Anordnung der VCSEL-Lichtquellen ist, bedingt durch einen homogeneren, näherungsweise eindimensionalen Wärmefluss, der thermische Widerstand geringer als bei einem Array kantenemittierender Diodenlaser. Die Kontaktfläche zwischen Bereichen, in denen Hitze erzeugt wird, und der oder den Wärmesenken beträgt bei kantenemittierenden Diodenlaser typischerweise 0.1 cm², bei einem VCSEL-Array aber typischerweise 1.0 cm².

In diesem Zusammenhang ist es erwähnenswert, dass VCSEL außerdem im Gegensatz zu kantenemittierenden Diodenlasern ein relativ gut reproduzierbares Alterungsverhalten aufweisen. Spontanausfälle, beispielsweise durch Facettenzerstörung, treten relativ selten auf. Dies bedeutet eine verlängerte Gesamtlebensdauer des VCSEL-Arrays, da alle Emitter mit großer Wahrscheinlichkeit erst nach langer Zeit ausfallen; im Gegensatz zur Facettenzerstörung eines Kantenemitters, welche näherungsweise unabhängig von der Alterung mit einer bestimmten Rate auftritt. Die reproduzierbare Alterung kann vorteilhafterweise dadurch genutzt werden, das die Leistung eines Referenzemitters gemessen wird, so dass ein Ausgleich des Leistungsverlustes durch Alterung des Referenzemitters und einer zugeordneten Gruppe von Emittern vorgenommen werden kann, ohne dass die Leistung jeden einzelnen Emitters bestimmt oder gemessen werden muss.

Neben der erwähnten Skalierbarkeit eines bevorzugt einzeln ansteuerbaren VCSEL-Arrays ist bedeutungsvoll, dass aufgrund der systemimmanenten Eigenschaften von VCSEL-Arrays eine kostengünstigere Einrichtung im Vergleich zu einer Einrichtung, welche kantenemittierende Laserdioden verwendet erreicht werden kann. Darüber hinaus sind die geometrischen Abmessungen eines VCSEL-Arrays erheblich kleiner, so dass eine sehr kompakte Bebilderungseinrichtung für Druckformen geschaffen werden kann.

Über die inkoherente Fokussierung des Lichtes wenigstens zweier VCSEL-Lichtquellen in einem Bebilderungskanal auf denselben Punkt kann es vorteilhaft sein, die VCSEL-Lichtquellen in dem Bebilderungskanal zugeordneten Teilarray derart anzusteuern, dass das von einer VCSEL-Lichtquelle emittierte Licht zum von einer zweiten VCSEL-Lichtquelle emittierten Licht eine feste Phasenbeziehung aufweist. Unter Ausnutzung konstruktiver Interferenzeffekte kann ein Strahl gebildet werden, welcher eine hohe Ausgangsleistung in Verbindung mit einer hohen Strahlqualität besitzt. Um einen bestimmten Bildpunkt zu erzeugen, ist es daher erforderlich, in diesem Fall die entsprechenden VCSEL-Lichtquellen gleichzeitig anzusteuern. Mit anderen Worten mehrere Emitter, also VCSEL-Lichtquellen, sind somit zu einem Bebilderungskanal zusammengefasst.

Die erfindungsgemäße Einrichtung zur Bebilderung einer Druckform kann mit besonderem Vorteil in einem Druckformbelichter oder in einem Druckwerk zum Einsatz kommen. Es kann sich dabei sowohl um Flachbettbelichter als auch auf gekrümmten Aufnahmeelementen, beispielsweise auf einem Zylinder, aufgenommene Druckformen handeln. Die zweidimensionale Oberfläche der Druckform wird von den Bildpunkten der Einrichtung zur Bebilderung in einer schnellen und einer langsamen Vorschubrichtung (linear unabhängige Richtungen, nicht notwendigerweise senkrecht zueinander) überstrichen. Eine erfindungsgemäße Druckmaschine welche wenigstens einen Anleger, ein Druckwerk und einen Ausleger umfasst (Bogendruckmaschine), weist wenigstens ein Druckwerk mit einer erfindungsgemäßen Einrichtung zur Bebilderung einer Druckform auf. Alternativ dazu kann auch eine bahnverarbeitende Druckmaschine eine erfindungsgemäße Einrichtung aufweisen. Bevorzugt ist die Druckmaschine eine direkte oder indirekte Flachdruckmaschine, insbesondere eine Offsetdruckmaschine.

Eine zweidimensionale Anordnung des Arrays kann dabei in vorteilhafter Weise derart sein, dass die r Spalten (mit s VCSEL-Lichtquellen) im wesentlichen senkrecht zur schnellen Vorschubrichtung liegen, also die s Zeilen des Arrays im wesentlichen senkrecht zur langsamen Vorschubrichtung liegen. Wenn q der Abstand zweier benachbarter Oberflächenemitter und d der Abstand zweier Linien auf der Druckform sind, so ist bevorzugt s = q/d. Um eine x-fache Redundanz zu erzeugen, ist bevorzugt s = x*q/d. Eine geringe Empfindlichkeit gegenüber Verkippung des Arrays und zeitliche Ansteuerungsfehler kann durch eine geometrische Anordnung, bei welcher der maximale Abstand in der schnellen Vorschubrichtung zweier VCSEL-Lichtquellen, welche benachbarte Linien schreiben, kleiner als s*q ist, erreicht werden.

Durch die Verwendung eines sehr großen Arrays, beispielsweise modular aufgebaut aus Unterarrays, ist eine 1:1 Bebilderung möglich. Mit anderen Worten die gesamte zu bebildernde Fläche der Druckform mit einer bestimmten Anzahl von Druckpunkten wird mittels derselben Anzahl von Bebilderungskanälen belichtet. Insbesondere bei der Flachbettbelichtung kann dies vorteilhaft sein, um einen sehr schnellen Druckformbelichter zu realisieren. Aufgrund der vorteilhaften Strahleigenschaften von VCSEL-Lichtquellen kann eine relativ einfache Abbildungsoptik verwendet werden, oder aber bei einem sehr kleinen Bebilderungsabstand eine direkte Bebilderung ohne Abbildungsoptik erfolgen.

Es ist erwähnenswert, dass es sich bei der Druckform sowohl um eine konventionelle Druckform, also beispielsweise eine übliche thermische Druckform, als auch um eine wiederbeschreibbare Druckform, eine Druckfolie oder einen Film handeln kann. Im Fall einer digital bebilderbaren Druckform, deren Empfindlichkeit auf einer bestimmten Wellenlänge des Bebilderungslichts extremal wird, müssen VCSEL-Lichtquellen mit korrespondierenden Emissionswellenlängen verwendet werden. In bestimmten Anwendungen kann es vorteilhaft sein, die VCSEL-Lichtquellen nicht im CW-Modus, also zur Emission kontinuierlicher Strahlung, sondern zur Erzeugung von Kurzpulsstrahlung zu verwenden.

Weitere Vorteile und vorteilhafte Ausführungsformen und Weiterbildungen der Erfindung werden anhand der nachfolgenden Figuren sowie deren Beschreibungen dargestellt. Es zeigen im einzelnen:
- Figur 1: eine schematische Darstellung einer erfindungsgemäßen Einrichtung zur Bebilderung einer Druckform mit einem Array von VCSEL-Lichtquellen und einer Abbildungsoptik zur Erzeugung von Bildpunkten auf der Druckform,
- Figur 2: eine schematische Darstellung einer vorteilhaften Ausführungsform der erfindungsgemäßen Einrichtung zur Bebilderung einer Druckform mit einem Array von VCSEL-Lichtquellen, welche Teilarrays umfasst, und mit einer Abbildungsoptik, welche einzelne Komponenten aufweist,
- Figur 3: eine schematische Darstellung einer alternativen Ausführungsform der erfindungsgemäßen Einrichtung zur Bebilderung einer Druckform mit einem Array von VCSEL-Lichtquellen, welches Teilarrays umfasst, und mit einer Abbildungsoptik, welche einzelne Komponenten aufweist,
- Figur 4: eine schematische Darstellung einer Ausführungsform mit einem aus Unterarrays modular zusammengesetzten Arrays von VCSEL-Lichtquellen in der erfindungsgemäßen Einrichtung zur Bebilderung einer Druckform,
- Figur 5: eine schematische Darstellung einer alternativen Ausführungsform mit einem aus Unterarrays modular zusammengesetzten Array von VCSEL-Lichtquellen in der erfindungsgemäßen Einrichtung nebst einer Topologie einer Ausgangsleistungsdetektion eines Referenzemitters,
- Figur 6: eine schematische Darstellung des Einsatzes einer erfindungsgemäßen Einrichtung mit einer auf einem Zylinder aufgenommenen Druckform.

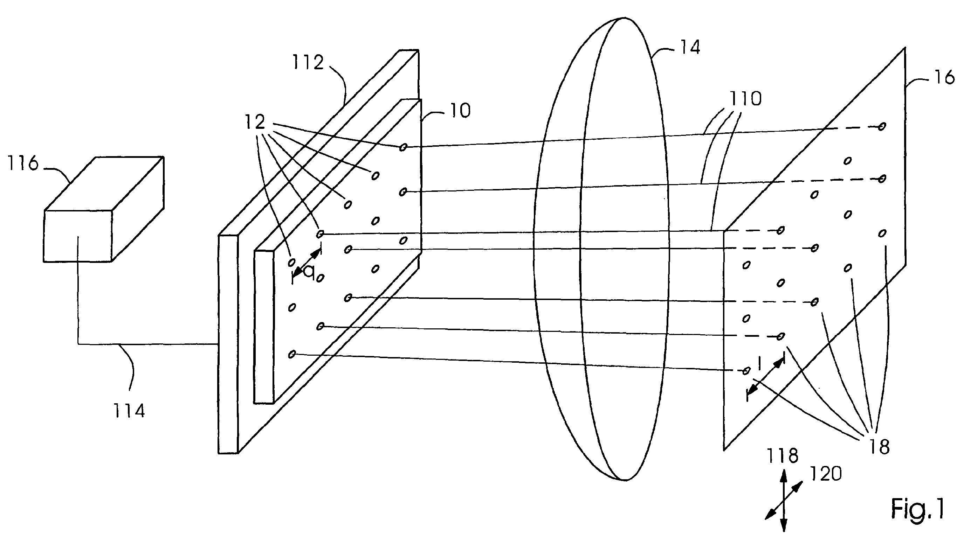

Die Figur 1 zeigt eine schematische Darstellung einer erfindungsgemäßen Einrichtung zur Bebilderung einer Druckform mit einem Array von VCSEL-Lichtquellen und einer Abbildungsoptik zur Erzeugung von Bildpunkten auf der Druckform. Das Array von Lichtquellen 10 weist einzelne Emitter auf, welche VCSEL-Lichtquellen 12 umfassen. Beispielhaft gezeigt haben diese VCSEL-Lichtquellen einen Abstand q, im allgemeinen Fall können sich die Abstände der Emitter in den zwei linear unabhängigen die Fläche aufspannenden Richtungen auch unterscheiden. Beispielhaft ist in Figur 1 ein Array von 3 x 5 VCSEL-Lichtquellen 12 gezeigt, im allgemeinen Fall umfasst das Array 10 aber n x m VCSEL-Lichtquellen 12, wobei n und m natürliche Zahlen sind.

Mittels einer Abbildungsoptik 14 werden auf einer Druckform 16 Bildpunkte 18 erzeugt, welche einen Abstand 1 benachbarter Bildpunkte aufweisen. Für das Wesen der erfindungsgemäßen Einrichtung ist es dabei unerheblich, ob der Abstand 1 benachbarter Bildpunkte gleich dem Abstand zu setzender Druckpunkte p ist oder ob es sich um einen Abstand 1 benachbarter Bildpunkte handelt, welcher größer als der Abstand zu bebildernder Druckpunkte p ist. In diesem Fall ist es erforderlich, eine Translation der Bildpunkte relativ zur Druckform derart durchzuführen, dass eine Bebilderung in einem Interleaf-Verfahren erreicht wird.

Die VCSEL-Lichtquellen 12 des Arrays von Lichtquellen 10 sind einzeln ansteuerbar. Repräsentativ dafür sind hier Bebilderungslichtstrahlen 110 einzelner angesteuerter VCSEL-Lichtquellen 12 gezeigt. Das Array von Lichtquellen 10 ist auf einer Versorgungseinheit 112 aufgenommen. Diese Versorgungseinheit 112 steht in Verbindung zum Austausch von Daten und/oder Steuersignalen 114 in Kontakt mit einer Steuerungseinheit 116. Wie bereits oben erwähnt, sind hier in Figur 1 nicht gezeigte Mittel vorgesehen, die Druckform 16 relativ zu den Bildpunkten 18 des Arrays von Lichtquellen 10 zu bewegen, um auf der Druckform 16 Druckpunkte zu setzen. Zur dichten Füllung einer zweidimensionalen Fläche auf der Druckform 16 ist sowohl eine Bewegung in eine erste Richtung 118 als auch eine zweite Richtung 120, welche die Fläche der Druckform 16 aufspannen, vorgesehen.

In einer besonders vorteilhaften Weiterbildung der Erfindung ist vorgesehen, das Array von Lichtquellen 10 derart ausgedehnt in eine Dimension der zweidimensionalen Druckform, sei sie plan oder wenigstens teilweise gekrümmt, vorzusehen, dass die ganze Format- oder Seitenbreite, also wenigstens die Breite der bildmäßigen Druckfläche auf der Druckform 16, im wesentlichen parallel bebildert werden kann. Auf eine Bewegung der Einrichtung zur Bebilderung in diese Richtung kann dann verzichtet werden, so dass schnell und präzise eine Bebilderung durchgeführt werden kann.

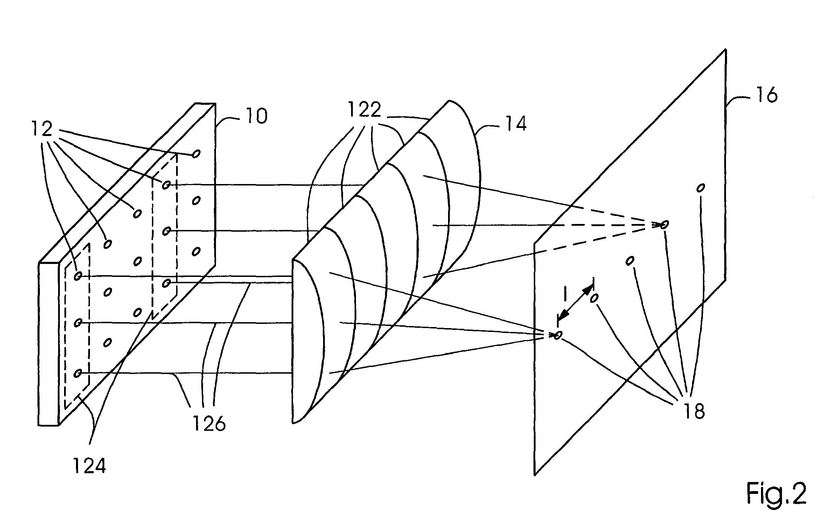

Die Figur 2 ist eine schematische Darstellung einer vorteilhaften Ausführungsform der erfindungsgemäßen Einrichtung zur Bebilderung einer Druckform mit einem Array von VCSEL-Lichtquellen, welche Teilarrays umfasst, und mit einer Abbildungsoptik, welche einzelne Komponenten aufweist. Die Figur 2 zeigt ein Array von Lichtquellen 10, welches einzelne VCSEL-Lichtquellen 12 umfasst, eine Abbildungsoptik 14, welche einzelne Komponenten 122 aufweist, und eine Druckform 16. Eine Untermenge der Gesamtmenge der VCSEL-Lichtquellen 12 bildet ein Teilarray 124. Typischerweise sind Teilarrays 124 disjunkt zueinander und ergänzen sich zur Gesamtmenge der VCSEL-Lichtquellen 12. Beispielhaft ist in dieser Figur 2 ein Array von Lichtquellen 10 bestehend aus 3 x 5 VCSEL-Lichtquellen 12 gezeigt. Im allgemeinen Fall handelt es sich um ein Array von Lichtquellen 10 aus n x m VCSEL-Lichtquellen 12, wobei n und m natürliche Zahlen sind. Beispielhaft umfasst ein Teilarray 124 drei VCSEL-Lichtquellen einer Spalte, also der drei unterschiedlichen Zeilen. Die Abbildungsoptik 14 ist dabei derart in Komponenten 122 ausgeführt, dass das von einem Teilarray 124 emittierte Licht, hier die Bebilderungslichtstrahlen 126 des Teilarrays, in einen Bildpunkt 18 auf der Druckform konvergiert werden. Mit anderen Worten, die VCSEL-Lichtquellen 12 eines bestimmten Teilarrays 124 sind die Lichtquellen eines Bebilderungskanals zur Erzeugung eines Bildpunkts 18 auf der Druckform. In diesem Zusammenhang ist es, wie bereits an anderer Stelle erwähnt, unerheblich ob der Abstand 1 benachbarter Bildpunkte auf der Druckform gleich dem Abstand benachbarter Bildpunkte p oder größer als dieser ist. Bevorzugt sind Teilarray 124 des Arrays von Lichtquellen 10 derart ausgeführt, dass das von den VCSEL-Lichtquellen 12 des Teilarrays 124 emittierte Licht zu Bildpunkten 18 auf der Druckform 16 konvergiert werden, welche im wesentlichen auf einer Linie auf der Druckform liegen. Es entsteht somit eine Gruppe von Bildpunkten, welche zur Erzeugung von Rasterscanlinien bzw. Bebilderungszeilen auf der Druckform 16 über diese in die linear unabhängigen Richtungen, welche die Fläche der Druckform 16 aufspannen, bewegt werden können.

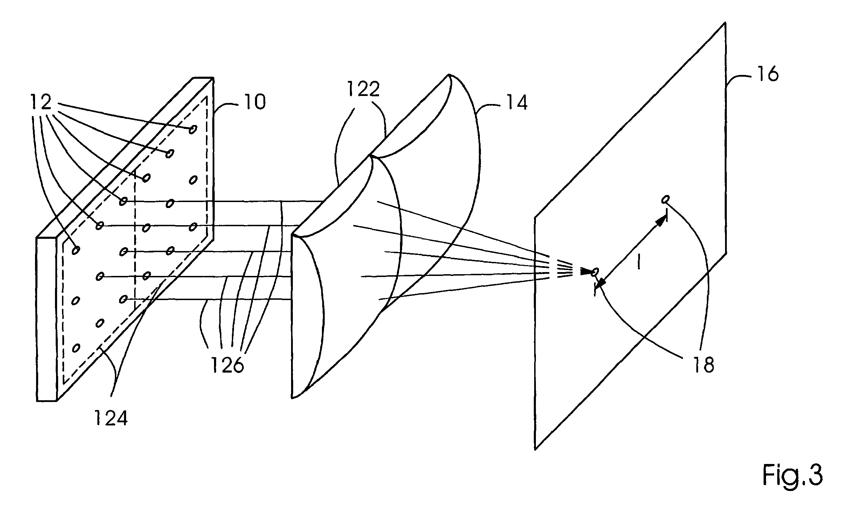

In der Figur 3 ist eine schematische Darstellung einer alternativen Ausführungsform der erfindungsgemäßen Einrichtung zur Bebilderung einer Druckform mit einem Array von VCSEL-Lichtquellen, welche Teilarrays umfasst, und mit einer Abbildungsoptik, welche einzelne Komponenten aufweist, gezeigt. Die Einrichtung zur Bebilderung einer Druckform umfasst dabei ein Array von Lichtquellen 10 mit VCSEL-Lichtquellen 12, einer Abbildungsoptik 14, welche Komponenten 122 aufweist und eine Druckform 16. Beispielhaft ist in der Figur 3 ein Array von 3 x 6 VCSEL-Lichtquellen 12 gezeigt. Dieses Array von Lichtquellen 10 weist dabei beispielhaft zwei 3 x 3 Teilarrays 124 auf. Die Abbildungsoptik 14 ist derart ausgeführt, das eine Komponente 122 die Bebilderungsstrahlen 126 des Teilarrays 124 in einem Bildpunkt 18 auf der Druckform 16 bündelt.

In einer vorteilhaften Weiterbildung der Ausführungsformen der Erfindung gemäß Figur 2 oder Figur 3 kann wenigstens eine Komponente 122 der Abbildungsoptik 14, welche auf ein Teilarray 124 des Arrays 10 von VCSEL-Lichtquellen 12 wirkt, auch als Mikrooptik ausgeführt sein. Insbesondere ist es besonders vorteilhaft, wenn die Komponenten 122 relativ gegeneinander bewegbar sind.

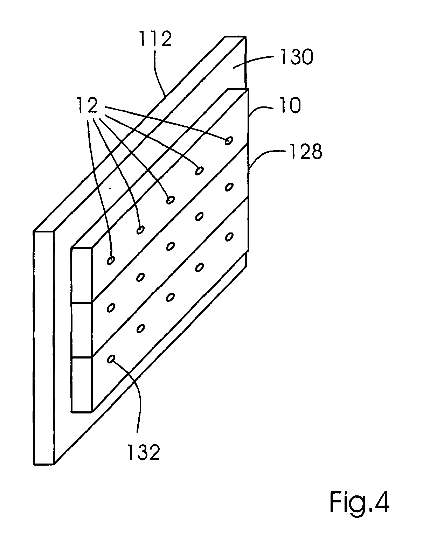

Die Figur 4 zeigt eine schematische Darstellung einer Ausführungsform mit einem aus Unterarrays modular zusammengesetzten Array von VCSEL-Lichtquellen in der erfindungsgemäßen Einrichtung zur Bebilderung einer Druckform. Das Array von Lichtquellen 10 mit VCSEL-Lichtquellen 12 besteht hier beispielhaft aus drei Lichtquellenmodulen 128 welche hier beispielhaft jeweils fünf VCSEL-Lichtquellen 12 in einer Reihe angeordnet aufweisen. Die Lichtquellenmodule 128 sind nebeneinander derart angeordnet, dass ein 3 x 5 Arrray von Lichtquellen 10 entsteht. Als Aufnahmeelement 130 dient bevorzugt eine Oberfläche der Versorgungseinheit 122 des Arrays von Lichtquellen 10. Für ein Lichtquellenmodul 128 kann ein Referenzemitter 132 bestimmt sein. Dieser Referenzemitter 132 wird zur Diagnostik emissionsrelevanter Parameter vorgesehen. Bei den emissionsrelevanten Parametern handelt es sich beispielsweise um den Versorgungsstrom oder aber um die Ausgangsleistung der VCSEL-Lichtquelle.

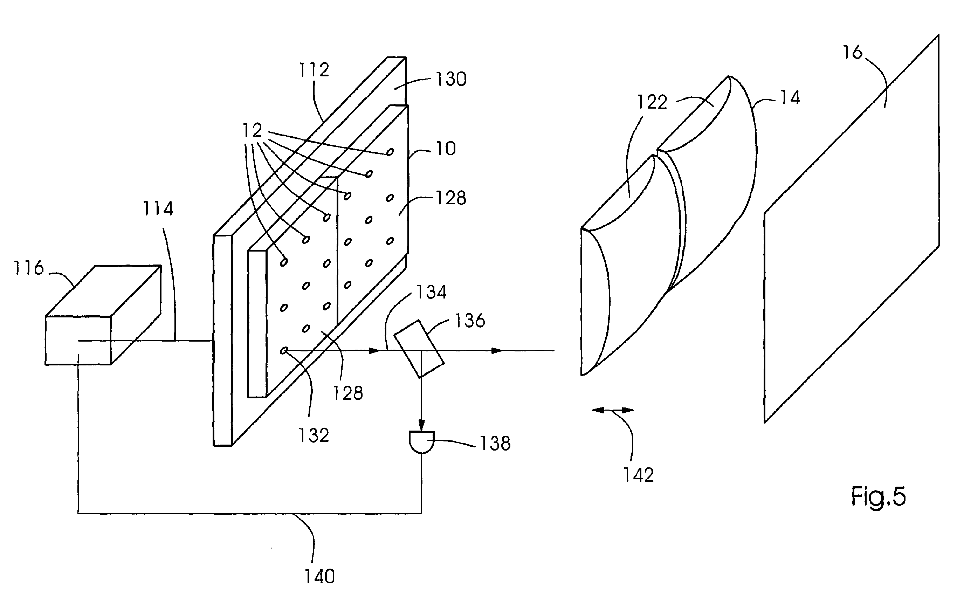

In der Figur 5 ist eine schematische Darstellung einer alternativen Ausführungsform mit einem aus Unterarrays modular zusammengesetzten Array von VCSEL-Lichtquellen nebst einer Topologie einer Ausgangsleistungsdetektion eines Referenzemitters. Die Einrichtung zur Bebilderung einer Druckform umfasst ein Array von Lichtquellen 10 mit VCSEL-Lichtquellen 12, eine Abbildungsoptik 14, welche Komponenten 122 aufweist, und eine Druckform 16. In dieser beispielhaft gezeigten Ausführungsform ist das 3 x 6 Array 10 von VCSEL-Lichtquellen 12 aus zwei Lichtquellenmodulen 128 zusammengesetzt. Die Lichtquellenmodule 128 weisen jeweils 3 x 3 VCSEL-Lichtquellen 12 auf. Als Aufnahmeelement 130 dient eine Oberfläche der Versorgungseinheit 112. Mittels einer Verbindung zum Austausch von Daten und/oder Steuersignalen 114 ist die Versorgungseinheit 112 in Kontakt mit einer Steuerungseinheit 116. Auf einem Lichtquellenmodul 128 ist ein Referenzemitter 132 vorgesehen. Beispielhaft ist hier gezeigt, dass dieser Referenzemitter 132 einem Bebilderungsstrahl 134 zur Bebilderung der Druckform 16 emittiert. Mittels eines Strahlteilers 136 bekannten Teilungsverhältnisses wird ein Teil des emittierten Lichtes des Bebilderungsstrahls 134 ausgekoppelt und auf einen Detektor 138 gelenkt. Über eine Verbindung 114 gelangt das Signal des Detektors 138 zur Weiterverarbeitung in die Steuerungseinheit 116. Es ist somit möglich, eine Regelung zu realisieren, durch welche die Eingangsleistung wenigstens einer VCSEL-Lichtquelle hier des Referenzemitters 132, in Funktion der Ausgangsleistung dieser Lichtquelle variiert wird, wenn die Ausgangsleistung von einem Sollwert abweicht. Darüber hinaus kann ein Referenzemitter 132 eines Teilarrays 128 des Arrays 10 von VCSEL-Lichtquellen 12 in einer Regelung derart verwendet werden, dass in Funktion der Ausgangsleistung des Referenzemitters die Eingangsleistung wenigstens einer weiteren VCSEL-Lichtquelle 12 des Teilarrays 128 variiert wird, wenn die Ausgangsleistung von einem Sollwert abweicht.

Des Weiteren ist es besonders vorteilhaft, wenn wenigstens eine Komponente 122 der Abbildungsoptik 14 für ein Teilarray 128 des Arrays 10 von VCSEL-Lichtquellen derart in eine Verschiebungsrichtung 142 bewegbar ist, dass die Lage des nachgeordneten Fokus in Funktion des Abstandes des Arrays von VCSEL-Lichtquellen 12 zur Druckform 16 veränderbar ist. Dem Fachmann ist in diesem Zusammenhang bekannt, dass der Wert einer Abstandsmessung zwischen Lichtquellen 12 und Druckform 16 als Eingangsparameter für eine Autofokusregelung dienen kann, um welche die erfindungsgemäße Einrichtung zur Bebilderung einer Druckform vorteilhaft weitergebildet werden kann.

Alternativ zu der in Figur 5 gezeigten Topologie einer Ausgangsleistungsdetektion ist es ebenfalls möglich, die Ausgangsleistung wenigstens eines Referenzemitters 132 direkt an der VCSEL-Lichtquelle 12 an einem Resonatorspiegel zu messen.

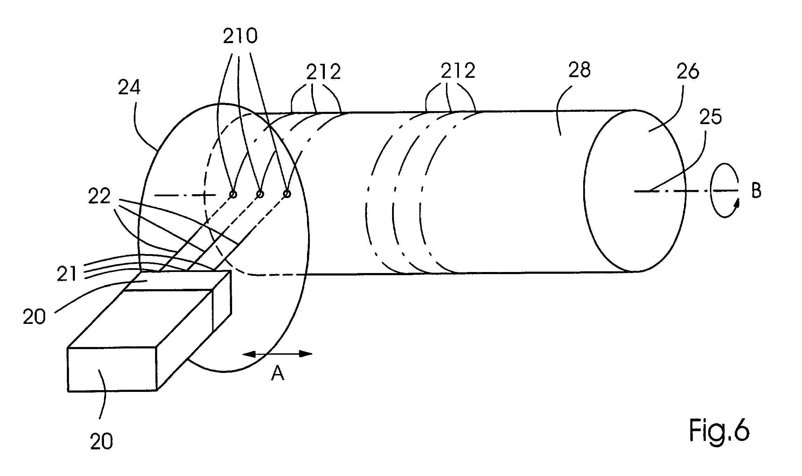

In der Figur 6 wird die Bebilderung einer Druckform gezeigt, welche sich auf einem rotierbaren Zylinder befindet. Das Array von Lichtquellen 20 mit VCSEL-Lichtquellen 21 erzeugt hierbei beispielhaft drei Bebilderungslichtstrahlen 22, welche mittels der Abbildungsoptik 24 auf drei Bildpunke 210 abgebildet werden. Vorteilhafterweise haben die Bildpunkte einen gleichmäßigen Abstand zueinander und liegen auf einer Achse. Die Druckform 28 befindet sich auf einem Zylinder 26, welcher um seine Symmetrieachse 25 drehbar ist. Diese Drehung ist durch den Pfeil B bezeichnet. Das Array von Lichtquellen 20 kann parallel zur Symmetrieachse 25 des Zylinders auf im wesentlichen linearem Wege bewegt werden, welches mit dem Doppelpfeil A gekennzeichnet ist. Zur kontinuierlichen oder gepulsten Bebilderung rotiert der Zylinder 26 mit der Druckform 28 gemäß der Rotationsbewegung b, und das Array von Lichtquellen 20 mit der Versorgungseinheit 23 translatiert längs des Zylinders gemäß der Bewegungsrichtung A. Es ergibt sich eine Bebilderung, welche auf schraubenförmigem Wege 212 die Symmetrieachse 25 des Zylinders 26 umläuft. Der Weg der Bildpunkte 210 ist durch die Linien 212 angedeutet. Mit anderen Worten: Nach erfolgter Bebilderung von in diesem Fall drei Punkten erfolgt eine relative Verschiebung von Druckform 28 und Bildpunkten 210 mit einer Vektorkomponente senkrecht zu der durch die Linie der drei Bildpunkte definierten Richtung um einen ersten bestimmten Betrag, so dass an einer anderen Stelle der Druckform 28 erneut drei Punkte geschrieben werden können. Dadurch entstehen sogenannte Rasterscanlinien von Bildpunkten. Zu jedem bestimmten Abstand benachbarter Rasterscanlinien, also Abstand 1 benachbarter Bildpunkte und Anzahl der Bildpunkte ergibt sich ein zweiter bestimmter Betrag einer notwendigen Verschiebung parallel zu der durch die Line der drei Bildpunkte definierten Achse, so dass eine dichte Bebilderung, d.h. die Bebilderung jedes vorgesehenen Druckpunktes auf der Druckform 28.

In anderen Worten ausgedrückt, wenn das Lichtquellenarray 20 derart orientiert ist, dass n Bebilderungsstrahlen 22 erzeugt werden, deren Achse im wesentlichen parallel zur Translationsrichtung A liegt, dann bewegen sich die n Bildpunkte 210 entlang n Helices über den in Richtung B rotierenden Zylinder 26. Betrachtet man einen Azimuthalwinkel, so sind die n Helices ineinander verschränkt. In Richtung parallel zur Rotationsachse 25 gesehen an diesem Azimuthalwinkel, ist ein Hub der Helices erforderlich, wie er den Vorschubregeln eines Interleafrasterscanlinien-Verfahrens entspricht, um ein doppeltes Überstreichen von Punkten der Oberfläche des Zylinders 26 zu vermeiden, wenn die durch die n Helices erzeugten Bildpunkte 210 nicht dicht liegen.

Die gezeigte Einrichtung zur Bebilderung gemäß Figur 6 kann an einem Zylinder 26 in einem Druckwerk ausgeführt sein. Ein derartiges Druckwerk kann Teil einer Druckmaschine sein.

### Bezugszeichenliste

- 10: Lichtquellenarray
- 12: VCSEL-Lichtquelle
- 14: Abbildungsoptik
- 16: Druckform
- 18: Bildpunkt
- 110: Bebilderungslichtstrahl
- 112: Versorgungseinheit
- 114: Verbindung zum Austausch von Daten und/oder Steuersignalen
- 116: Steuerungseinheit
- 118: Erste Bewegungsrichtung
- 120: Zweite Bewegungsrichtung
- 122: Komponente
- 124: Teilarray
- 126: Bebilderungslichtstrahl des Teilarrays
- 128: Lichtquellenmodul
- 130: Aufnahmeelement
- 132: Referenzemitter
- 134: Bebilderungsstrahl des Referenzemitters
- 136: Strahlteiler
- 138: Detektor
- 140: Signalverbindung
- 142: Verschiebungsrichtung
- 20: Lichtquellenarray
- 21: VCSEL-Lichtquelle
- 22: Bebilderungslichtstrahl
- 23: Versorgungseinheit
- 24: Abbildungsoptik
- 25: Rotationsachse
- 26: Zylinder
- 28: Druckform
- 210: Bildpunkte
- 212: Weg der Bildpunkte
- q: Abstand Emitter
- 1: Abstand benachbarter Bildpunkte
- p: Abstand von Druckpunkten
- A: Translationsrichtung
- B: Rotationsrichtung

## Patentansprüche

1. Einrichtung zur Bebilderung einer Druckform (16) mit einem Array (10) von Lichtquellen (12) und einer Abbildungsoptik (14) zur Erzeugung von (n x m) Bildpunkten (18) auf der Druckform (16), wobei n>1 und m>=1 natürliche Zahlen sind,
**dadurch gekennzeichnet,**
**dass** das Array (10) von Lichtquellen (12) ein Array von (r x s) VCSEL-Lichtquellen (12) umfasst, wovon wenigstens zwei VCSEL-Lichtquellen (12) unabhängig voneinander ansteuerbar sind, wobei r>=n und s>=m natürliche Zahlen sind.

2. Einrichtung zur Bebilderung einer Druckform (16) gemäß Anspruch 1,
**dadurch gekennzeichnet,**
**dass** wenigstens ein bestimmter Bildpunkt (18) auf der Druckform (16) durch die Zusammenführung des von einem Teilarray (124) der (r x s) VCSEL-Lichtquellen (12) emittierten Lichtes, also wenigstens zweier VCSEL-Lichtquellen (12), entsteht.

3. Einrichtung zur Bebilderung einer Druckform (16) gemäß Anspruch 1 oder Anspruch 2,
**dadurch gekennzeichnet,**
**dass** das Array von VCSEL-Lichtquellen (12) modular aus einer Anzahl von Unterarrays (128) aufgebaut ist.

4. Einrichtung zur Bebilderung einer Druckform (16) gemäß einem der oberen Ansprüche,
**dadurch gekennzeichnet,**
**dass** eine Reihe von n Bildpunkten (18) auf der Druckform mit einem Abstand 1 benachbarter Punkte erzeugt wird.

5. Einrichtung zur Bebilderung einer Druckform (16) gemäß einem der Ansprüche 2 bis 4,
**dadurch gekennzeichnet,**
**dass** wenigstens eine erste und eine zweite VCSEL-Lichtquelle (12) in einem Teilarray (124) derart angesteuert werden, dass das von der ersten VCSEL-Lichtquelle (12) emittierte Licht von der zweiten VCSEL-Lichtquelle (12) emittierte Licht eine feste Phasenbeziehung aufweist.

6. Einrichtung zur Bebilderung einer Druckform (16) gemäß einem der oberen Ansprüche,
**dadurch gekennzeichnet,**
**dass** wenigstens eine Komponente (122) der Abbildungsoptik (14) welche auf wenigstens ein Teilarray (124) des Arrays von VCSEL-Lichtquellen (12) wirkt, als Mikrooptik ausgeführt ist.

7. Einrichtung zur Bebilderung einer Druckform (16) gemäß einem der oberen Ansprüche,
**dadurch gekennzeichnet,**
**dass** in wenigstens einem Teilarray (124) des Arrays von VCSEL-Lichtquellen (12) eine VCSEL-Lichtquelle als Referenzemitter (132) zur Diagnostik emissionsrelevanter Parameter vorgesehen ist.

8. Einrichtung zur Bebilderung einer Druckform (16) gemäß einem der oberen Ansprüche,
**dadurch gekennzeichnet,**
**dass** wenigstens die Abbildungsoptik (14) für einem Teilarray (124) des Arrays von VCSEL-Lichtquellen (12) eine Komponente (122) aufweist, deren Fokuslage in Funktion des Abstandes des Arrays (10) von wenigstens einer VCSEL-Lichtquelle (12) zur Druckform (16) veränderbar ist.

9. Einrichtung zur Bebilderung einer Druckform gemäß einem der oberen Ansprüche,
**dadurch gekennzeichnet,**
**dass** wenigstens eine Lichtquelle des Arrays (10) von VCSEL-Lichtquellen (12) eine Regelung aufweist, welche in Funktion der Ausgangsleistung der Lichtquelle die Eingangsleistung variiert, wenn die Ausgangsleistung von einem Sollwert abweicht.

10. Einrichtung zur Bebilderung einer Druckform (16) gemäß Anspruch 9,
**dadurch gekennzeichnet,**
**dass** wenigstens ein Referenzemitter (132) eines Teilarrays (124) des Arrays von VCSEL-Lichtquellen (12) eine Regelung aufweist, welche in Funktion der Ausgangsleistung des Referenzemitters (132) die Eingangsleistung wenigstens einer weiteren Lichtquelle (12) des Teilarrays (124) variiert, wenn die Ausgangsleistung von einem Sollwert abweicht.

11. Einrichtung zur Bebilderung einer Druckform (16) gemäß einem der oberen Ansprüche,
**dadurch gekennzeichnet,**
**dass** wenigstens eine Lichtquelle des Arrays (10) von VCSEL-Lichtquellen (12) Kurzpulsstrahlung erzeugt.

12. Druckformbelichter,
**dadurch gekennzeichnet,**
**dass** der Druckformbelichter wenigstens eine Einrichtung zur Bebilderung einer Druckform (16) gemäß einem der Ansprüche 1 bis 11 aufweist.

13. Druckwerk,
**dadurch gekennzeichnet,**
**dass** das Druckwerk wenigstens einer Einrichtung zur Bebilderung einer Druckform (16) gemäß einem der Ansprüche 1 bis 11 aufweist.

14. Druckmaschine mit wenigstens einem Anleger, einem Druckwerk und einem Ausleger,
**dadurch gekennzeichnet,**
**dass** die Druckmaschine wenigstens ein Druckwerk gemäß Anspruch 13 aufweist.

## Claims

1. A device for recording images on a printing form (16) comprising an array (10) of light sources (12) and imaging optics (14) for generating (n x m) image dots (18) on the printing form (16) with n>1 and m>=1 being natural numbers,
**characterized in that**
the array (10) of light sources (12) comprises an array of (r x s) VCSEL-light sources (12), of which at least two VCSEL light sources (12) can be controlled independently of one another with r>=n and s>=m being natural numbers.

2. The device for recording images on a printing form (16) according to claim 1,
**characterized in that**
at least a specified image dot (18) forms on the printing form (16) by combining light emitted by a partial array (124) of the (r x s) VCSEL light sources (12), thus at least of two VCSEL light sources (12).

3. The device for recording images on a printing form (16) according to claim 1 or claim 2,
**characterized in that**
the array of VCSEL light sources (12) is built in a modular manner of a plurality of subarrays (128).

4. The device for recording images on a printing form (16) according to one of the above claims,
**characterized in that**
a row of n image dots (18) is produced on the printing form with a distance I of adjacent dots.

5. The device for recording images on a printing form (16) according to one of claims 2 to 4,
**characterized in that**
at least a first and a second VCSEL light source (12) are driven in a partial array (124) such that the light emitted from the first VCSEL light source (12) has a solid phase relation to the light emitted by the second VCSEL light source (12).

6. The device for recording images on a printing form (16) according to one of the above claims,
**characterized in that**
at least one component (122) of the imaging optics (14) which acts upon at least one partial array (124) of the array of VCSEL light sources (12) is designed as micro-optics.

7. The device for recoding images on a printing form (16) according to one of the above claims,
**characterized in that**
a VCSEL light source is provided in at least one partial array (124) of the array of VCSEL light sources (12) as a reference emitter (132) for diagnosing emission-relevant parameters.

8. The device for recording images on a printing form (16) according to one of the above claims,
**characterized in that**
at least the imaging optics (14) for a partial array (124) of the array of VCSEL light sources (12) has a component (122), the focal position of which can be modified to the printing form (16) in the function of the distance of the array (10) from at least one VCSEL light source (12).

9. The device for recording images on a printing form according to one of the above claims,
**characterized in that**
at least one light source of the array (10) of VCSEL light sources (12) has a control which, in the function of the output power of the light source, varies the input power when the output power deviates from a desired value.

10. The device for recording images on a printing form (16) according to claim 9,
**characterized in that**
at least one reference emitter (132) of a partial array (124) of the array of VCSEL light sources (12) has a control, which, in the function of the output power of the reference emitter (132), varies the input power of at least a further light source (12) of the partial array (124), when the output power deviates from a desired value.

11. The device for recording images on a printing form (16) according to one of the above claims,
**characterized in that**
at least one light source of the array (10) of VCSEL light sources (12) generates short-pulsed radiation.

12. A printing form imaging unit,
**characterized in that**
the printing form imaging unit comprises at least a device for recording images on a printing form (16) according to one of claims 1 to 11.

13. A printing unit,
**characterized in that**
the printing unit comprises at least a device for recording images on a printing form (16) according to one of claims 1-11.

14. A printing machine having at least a feeder, a printing unit and a delivery,
**characterized in that**
the printing machine comprises at least a printing unit according to claim 13.

## Revendications

1. Dispositif de formation d'image pour une plaque d'impression (16) avec une matrice (10) de sources lumineuses (12) et une optique de représentation (14) pour la génération de (n x m) points d'image (18) sur la plaque d'impression (16), n>1 et m≥1 étant des nombres naturels, **caractérisé en ce que** la matrice (10) de sources lumineuses (12) comprend une matrice de (r x s) sources lumineuses VCSEL (12), dont au moins deux sources lumineuses VCSEL (12) peuvent être activées indépendamment l'une de l'autre, r≥n et s≥m étant des nombres naturels.

2. Dispositif de formation d'image pour une plaque d'impression (16) selon la revendication 1, **caractérisé en ce qu'**au moins un point d'image (18) défini se forme sur la plaque d'impression (16) par le guidage commun de la lumière émise par une matrice partielle (124) des (r x s) sources lumineuses VCSEL (12), donc au moins de deux sources lumineuses VCSEL (12).

3. Dispositif de formation d'image pour une plaque d'impression (16) selon la revendication 1 ou la revendication 2, **caractérisé en ce que** la matrice de sources lumineuses VSCEL (12) est mise en place de façon modulaire à partir d'un certain nombre de sous-matrices (128).

4. Dispositif de formation d'image pour une plaque d'impression (16) selon l'une quelconque des revendications supérieures, **caractérisé en ce qu'**une série de n points d'image (18) est générée sur la plaque d'impression avec un espacement 1 de points voisins.

5. Dispositif de formation d'image pour une plaque d'impression (16) selon l'une quelconque des revendications 2 à 4, **caractérisé en ce qu'**au moins une première et une seconde sources lumineuses VCSEL (12) sont activées dans une matrice partielle (124) de telle sorte que la lumière émise par la première source lumineuse VCSEL (12) et par la seconde source lumineuse VCSEL (12) présente une relation de phase fixe.

6. Dispositif de formation d'image pour une plaque d'impression (16) selon l'une quelconque des revendications précédentes, **caractérisé en ce qu'**au moins un composant (122) de l'optique de représentation (14), qui agit sur au moins une matrice partielle (124) de la matrice de sources lumineuses VCSEL (12), est réalisé comme une micro-optique.

7. Dispositif de formation d'image pour une plaque d'impression (16) selon l'une quelconque des revendications précédentes, **caractérisé en ce que**, dans au moins une matrice partielle (124) de la matrice de sources lumineuses VSCEL (12), une source lumineuse VCSEL est prévue comme émetteur de référence (132) pour le diagnostic de paramètres importants au niveau de l'émission.

8. Dispositif de formation d'image pour une plaque d'impression (16) selon l'une quelconque des revendications précédentes, **caractérisé en ce que** au moins l'optique de représentation (14) pour une matrice partielle (124) de la matrice de sources lumineuses VCSEL (12) présente un composant (122), dont la position de foyer peut être modifiée en fonction de la distance de la matrice (10) d'au moins une source lumineuse VCSEL (12) à la plaque d'impression (16).

9. Dispositif de formation d'image pour une plaque d'impression (16) selon l'une quelconque des revendications précédentes, **caractérisé en ce qu'**au moins une source lumineuse de la matrice (10) de sources lumineuses VCSEL (12) présente un réglage qui modifie la puissance d'entrée en fonction de la puissance de sortie de la source lumineuse lorsque la puissance de sortie de sortie s'écarte d'une valeur de consigne.

10. Dispositif de formation d'image pour une plaque d'impression (16) selon la revendication 9, **caractérisé en ce qu'**au moins un émetteur de référence (132) d'une matrice partielle (124) de la matrice de sources lumineuses VCSEL (12) présente un réglage qui modifie en fonction de la puissance de sortie de l'émetteur de référence (132) la puissance d'entrée d'au moins une source lumineuse (12) de la matrice partielle (124) lorsque la puissance de sortie s'écarte d'une valeur de consigne.

11. Dispositif de formation d'image pour une plaque d'impression (16) selon l'une quelconque des revendications précédentes, **caractérisé en ce qu'**au moins une source lumineuse de la matrice (10) de sources lumineuses VCSEL (12) génère un rayonnement à courte impulsion.

12. Dispositif d'exposition de plaque d'impression, **caractérisé en ce que** le dispositif d'exposition de plaque d'impression présente un dispositif de formation d'image pour une plaque d'impression selon l'une quelconque des revendications 1 à 11.

13. Groupe d'impression, **caractérisé en ce que** le groupe d'impression présente au moins un dispositif de formation d'image pour une plaque d'impression (16) selon l'une quelconque des revendications 1 à 11.

14. Machine d'impression comprenant un margeur, un groupe d'impression et un receveur de feuilles, **caractérisée en ce que** la machine d'impression présente au moins un groupe d'impression selon la revendication 13.
